# EUROPEAN PATENT APPLICATION

(11) **EP 4 465 058 A2**
(43) Date of publication of application: **20.11.2024**
(21) Application number: 24173714.7
(22) Date of filing: 02.05.2024
(51) Int. Cl.: G01R 31/3185

(54) **CLUSTERING CLOCK CHAIN DATA FOR TEST-TIME REDUCTION**

(30) Priority: 18.05.2023 US 202318199065
(71) Applicant: STMicroelectronics International N.V., 1228 Plan-les-Ouates, Geneva (CH)
(72) Inventor: JAIN, Sandeep, 201301 Noida, Uttar Pradesh (IN); JAIN, Pooja, 201005 Sahibabad (IN); PAL, Esha, 208020 Kanpur, Uttar Pradesh (IN)
(74) Representative: Buzzi, Notaro & Antonielli d'Oulx S.p.A.

(57) **Abstract**

Test circuitry (10') is disclosed. An on-chip clock controller, OCC, (11) generates a test-clock (TSTCLK) based on clock-bits (CKBITS) received from a clock-chain (13), with the test-clock operating scan-chains (22) and the clock-chain (13). The clock-chain (13) receives m clock-chain input bits from m of n input-pins, m being less than n, and provides the clock-bits (CKBITS) to the OCC (11) for generating the test-clock (TSTCLK). The test circuitry (10') performs tests on the IC. Each test is associated with the test-clock (TSTCLK) generated by the OCC (11) based on a given set of clock-bits (CKBITS). Tests associated with the test-clock (TSTCLK) generated by the OCC (11) based on the same given set of clock-bits are performed after a single loading of that same given set of clock-bits (CKBITS).

## Description

### Technical Field

This disclosure is directed to the field of scan compression in the testing of integrated circuits, and in particular, to a modified architecture and loading technique for clock chain data that reduces or eliminates the use of dedicated input pins for the clock chain data, thereby allowing the reclaiming of these input pins to increase the number of inputs to a scan data compressor.

### Background

In the field of integrated circuit (IC) chip production, testing is performed to help identify potential manufacturing defects or functional issues that may affect the performance and dependability of the IC chip. Two common testing techniques employed for this purpose are Automatic Test Pattern Generation (ATPG) and Logic Built-In Self-Test (LBIST).

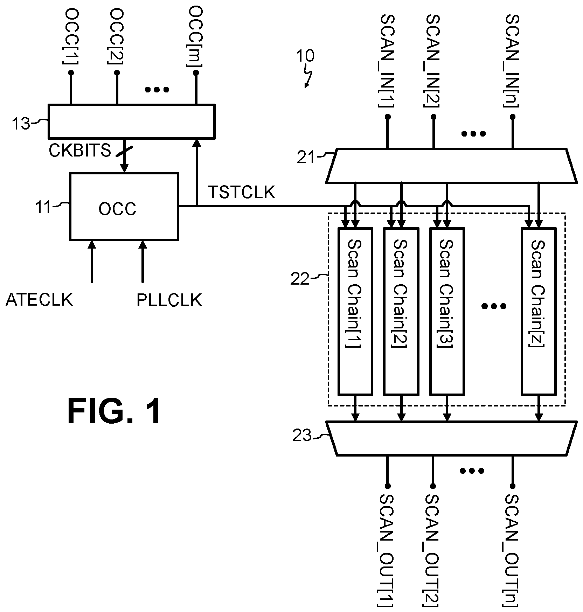

Test circuitry 10 within an IC chip is now described with reference to Figure 1. During testing, the core logic of the chip is temporarily reconfigured to incorporate scan chains 22, which are used to facilitate the efficient testing of the chip. For example, in Figure 1 are shown z scan chains labeled Scan Chain[1] to Scan Chain[z]. This reconfiguration effectively converts the sequential and combinational logic of the core logic into a shift-register-like structure. In this reconfigured state, the flip-flops within the scan chains 22 are interconnected with combinational logic elements within the core logic. This allows for the efficient testing of the chip by facilitating the shifting of test patterns and capturing response patterns for both ATPG and LBIST techniques.

A test clock TSTCLK is used to synchronize the operation of the scan chains 22 with the core logic of the chip during testing. This test clock TSTCLK is generated by an on-chip clock controller (OCC) 11 from an automated test equipment clock (ATECLK) and from a phase-locked loop clock (PLLCLK). The OCC 11 has its logic components configured to generate different patterns as the test clock TSTCLK for testing purposes based on clock bits CKBITS received from a clock chain 13. Throughout the course of testing, these clock bits CKBITS are changed in response to m clock chain input bits OCC[1], ..., OCC[m] received from m pins to produce the appropriate test clock signal TSTCLK patterns used for the various testing phases. This dynamic reconfiguration allows the OCC 11 to generate the desired test clock signal TSTCLK patterns, which are then used to control the operation of the scan chains 22 and the core logic of the chip.

Observe that there are z scan chains 22, clocked by the test clock TSTCLK, receiving input from a scan de-compressor 21, and providing output to a scan compressor 23. The scan de-compressor 21 takes n scan input bits SCAN_IN[1], ..., SCAN_IN[n] from n pins, decompresses the test data, and distributes the decompressed data among z scan chains 22, with z being greater than n. This enables a more efficient test data loading and unloading process. The scan compressor 23 receives the test response data from the outputs of the z scan chains 22, compresses the data, and reconstructs n scan output bits SCAN_OUT[1], ..., SCAN_OUT[n], allowing for the analysis of the chip's test results.

The efficiency of the testing process in an IC chip is impacted by the number of input pins available to the scan de-compressor 21. More input pins allow the scan de-compressor 21 to handle a larger volume of test data, enabling the loading of more scan chains in parallel during a given cycle, which in turn speeds up the testing process. However, increasing the number of pins on an IC chip can be a challenging and costly endeavor, as it involves expanding the footprint of the chip or making changes to the layout of the chip.

Considering these challenges, it would be advantageous if existing pins, which are already utilized for other purposes, could be used to provide additional scan input bits to the scan de-compressor 21. By repurposing or sharing these existing pins, the efficiency of the testing process could be improved without the need for modifications to the IC chip's design. As a result, there is a need for further development in this area.

### Summary

The invention is defined by the appended claims. Specifically, according to one or more embodiments, the above objective is achieved by means of a test circuitry for an integrated circuit and a related method for optimizing test circuitry in an integrated circuit. The claims are an integral part of the technical teaching of the disclosure provided herein.

Various embodiments of the present disclosure relate to test circuitry for an integrated circuit. The test circuitry includes a scan de-compressor that receives n scan input bits from n input pins and decompresses the n scan input bits for distribution among z scan chains as test data, where z is greater than n. The test circuitry also includes a scan compressor that receives test response data from the z scan chains and compresses the test response data to reconstruct n scan output bits. An on-chip clock controller (OCC) generates a test clock signal based on clock bits received from a clock chain, and the test clock signal operates the z scan chains and the clock chain. The clock chain is configured to receive m clock chain input bits from m of the n input pins, where m is less than n, and to provide the clock bits to the OCC for generating the test clock signal. Control circuitry controls the test circuitry to perform a plurality of tests on the integrated circuit, with each test being associated with the test clock signal generated by the OCC based on a given set of clock bits. The plurality of tests associated with the test clock signal generated by the OCC based on the same given set of clock bits are performed after a single loading of that same given set of clock bits.

The test circuitry may include clock-control logic or a pair of enable buffers that control the passing of the test clock signal to the clock chain and the z scan chains based on the assertion or deassertion of a load enable signal. The load enable signal can be received via a load enable pin. In addition, the test circuitry may include a pattern counter that counts the number of tests executed on the integrated circuit and asserts the load enable signal based on the count. Moreover, the pattern counter may also count the total number of clock chain input bits received by the clock chain during the performance of the plurality of tests and deassert the load enable signal when the total number of clock chain input bits becomes equal to a predetermined value.

Methods aspects are also disclosure herein, including a method for optimizing test circuitry in an integrated circuit. The method involves grouping tests to be performed by the test circuitry on the integrated circuit into a plurality of groups, according to which clock pattern is to be applied as a test clock to scan chains in the integrated circuit for each test, such that each test using the same clock pattern is in the same group. The method includes execution of each group of tests by loading a clock controller with a set of clock bits that configure the clock controller to generate the test clock having the clock pattern utilized by that group of tests, and performing each test of that group of tests using the test clock without reconfiguring the clock controller with a different set of clock bits between different tests of that group of tests.

The method may include receiving n scan input bits to be loaded into z scan chains at n input pins and compressing the n scan input bits to produce input data for the z scan chains, with z being greater than n. Each set of clock bits is received at m of the n input pins, with m being less than n. The method may also include deasserting and asserting a load enable signal to control the passage of the test clock to a clock chain and the scan chains before and after loading the clock controller with the set of clock bits associated with a group of the tests to be performed.

The method may also include counting the number of sets of clock bits that have been loaded in the clock controller or the number of tests performed on the integrated circuit, and asserting or deasserting the load enable signal based upon the count. The load enable signal may be received via a load enable pin. In addition, the method may include counting the total number of clock bits received during the performance of the tests and deasserting the load enable signal when the total number of those clock bits becomes equal to a predetermined value.

Also disclosed herein is a test circuitry for an integrated circuit. This test circuitry includes an on-chip clock controller (OCC) configured to generate a test clock signal based on clock bits received from a clock chain, with the test clock signal operating the clock chain. The clock chain is configured to receive m clock chain input bits from m of n input pins, where m is less than n, and to provide the clock bits to the OCC for generating the test clock signal. Control circuitry controls the test circuitry to perform a plurality of tests on the integrated circuit, with each test being associated with the test clock signal generated by the OCC based on a given set of clock bits. The plurality of tests associated with the test clock signal generated by the OCC based on the same given set of clock bits are performed after a single loading of that same given set of clock bits.

The test circuitry may include clock-control logic or a first enable buffer that controls the passing of the test clock signal to the clock chain based on the assertion of a load enable signal. The load enable signal can be received via a load enable pin. The test circuitry may include a pattern counter that counts the number of tests executed on the integrated circuit and asserts the load enable signal based on the count. The pattern counter may also count the total number of clock chain input bits received by the clock chain during the performance of the plurality of tests and deassert the load enable signal when the total number of clock chain input bits becomes equal to a predetermined value.

### Brief Description of the Drawings

For a better understanding of the embodiments, reference will now be made by way of example only to the accompanying figures in which:
Figure 1 is a block diagram of conventional test circuitry implemented in an integrated circuit.
Figure 2 is a block diagram of the improved test circuitry described herein, implemented in an integrated circuit.
Figure 3 is a diagrammatic representation of a prior art test clock pattern set.
Figure 4 is a diagrammatic representation of a grouped test clock pattern set as described herein.
Figure 5 is a block diagram of an alternative embodiment of the test circuitry described herein, implemented in an integrated circuit with the load enable pin removed.

### Detailed Description

The following disclosure enables a person skilled in the art to make and use the subject matter described herein. The general principles outlined in this disclosure can be applied to embodiments and applications other than those detailed above without departing from the spirit and scope of this disclosure. It is not intended to limit this disclosure to the embodiments shown, but to accord it the widest scope consistent with the principles and features disclosed or suggested herein.

Reference throughout this specification to "one embodiment" or "an embodiment" means that a particular feature, structure or characteristic described in connection with the embodiment is included in at least one embodiment. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

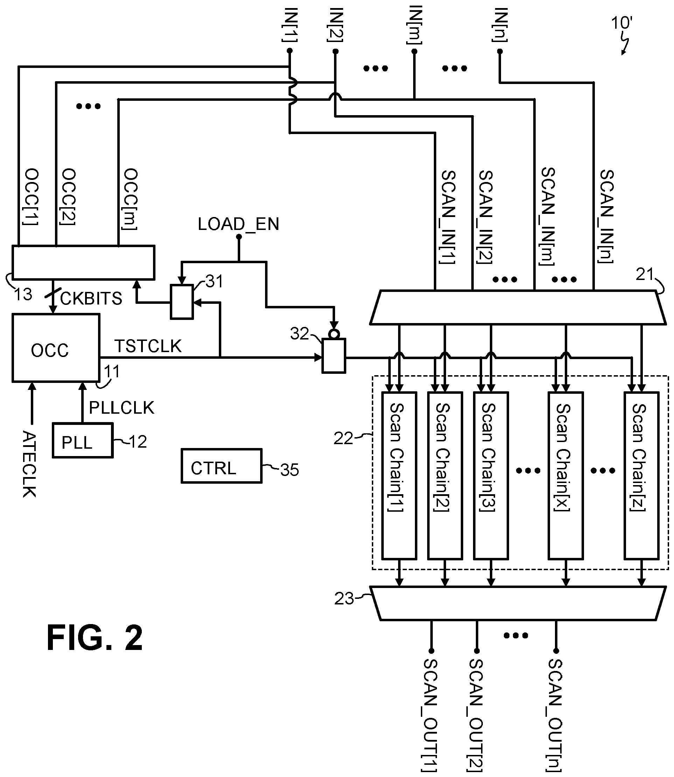

Figure 2 shows a test circuitry 10' according to the present disclosure. In the embodiment considered, the test circuitry 10' of Figure 2 is controlled by a control circuit 35 to perform testing operations. The test circuitry 10' includes z scan chains 22 clocked by the test clock TSTCLK, receiving input from a scan de-compressor 21, and providing output to a scan compressor 23. The scan de-compressor 21is configured to take n scan input bits SCAN_IN[1], ..., SCAN_IN[n] from n input pins IN[1], ..., IN[n], de-compresses the test data, and distributes the compressed data among z scan chains 22, with z being greater than n. This enables a more efficient test data loading and unloading process. The scan compressor 23 is configured to receive the test response data from the outputs of the z scan chains 22, compresses the data, and reconstructs n scan output bits SCAN_OUT[1], ..., SCAN_OUT[n], allowing for the analysis of the chip's test results.

In the embodiment considered, the test clock TSTCLK is generated by an on-chip clock controller (OCC) 11 from an automated test equipment clock ATECLK and from a phase-locked loop clock PLLCLK. The OCC 11 has its logic components configured to generate different patterns as the test clock TSTCLK for testing purposes based on clock bits CKBITS received from a clock chain 13 comprised of a series of flip flops. Throughout the course of testing, these clock bits CKBITS are changed in response to m clock chain input bits OCC[1], ..., OCC[m] received from m IN[1], ..., IN[m] of the n IN[1], ..., IN[n] input pins to produce the appropriate test clock signal TSTCLK patterns used for the various testing phases. It should be self-evident that m is less than n.

Observe here that, as opposed to the prior art, m of the n pins are not dedicated to either the scan de-compressor 21 and m scan inputs SCAN_IN[1], ..., SCAN_IN[m] or the clock chain 13 and m clock chain input bits OCC[1], ..., OCC[m]. Instead, m IN[1], ..., IN[m] of then IN[1], ..., IN[n] input pins are shared by both the scan de-compressor 21 and clock chain 13.

Also of note here is that, opposed to the prior art, in the embodiment considered, an enable logic 31 passes the test clock TSTCLK to the clock inputs of the clock chain 13 in response to assertion of a load enable signal LOAD_EN at a corresponding pin, while an enable logic 32 passes the test clock TSTCLK to the clock inputs of the scan chains 22 in response to deassertion of the load enable signal LOAD_EN.

The setting of these clock bits CKBITS will now be described. Recall that in the context of ATPG and LBIST testing techniques, different sets of clock bits CKBITS are utilized to generate various test clock TSTCLK patterns for different testing phases. These test clock TSTCLK patterns are utilized for controlling the operation of the scan chains 22 and the core logic of the IC chip during testing. Conventionally, the clock bits CKBITS are reloaded at each step of the test by changing the clock chain input bits OCC[1], ..., OCC[m] received from the m input pins IN[1], ..., IN[m] to generate the desired test clock signal TSTCLK patterns for the current testing phase.

However, this constant reloading of clock bits CKBITS for every testing phase can lead to increased testing time and complexity. To address this, an optimization technique is employed in the disclosed test circuitry 10' shown in Figure 2, which involves rearranging and grouping patterns with the same clock chain input bit values together. By doing so, the test patterns can be reordered in a way that involves less frequent reloading of the clock bits CKBITS, as the same clock bit values are used across multiple consecutive testing phases. This optimization reduces the time spent on reloading clock-data required for switching between different clock patterns during testing.

Note that in order to implement this optimization, the tests themselves are also to be reordered to correspond to the reordered clock bits CKBITS. This helps ensure that the testing process still meets the desired functional and performance requirements of the chip while taking advantage of the reduced clock bit reloading. The reordered tests will still adhere to the specific ATPG and LBIST techniques being used and their requirements, so that the testing objectives are met and accurate results are obtained.

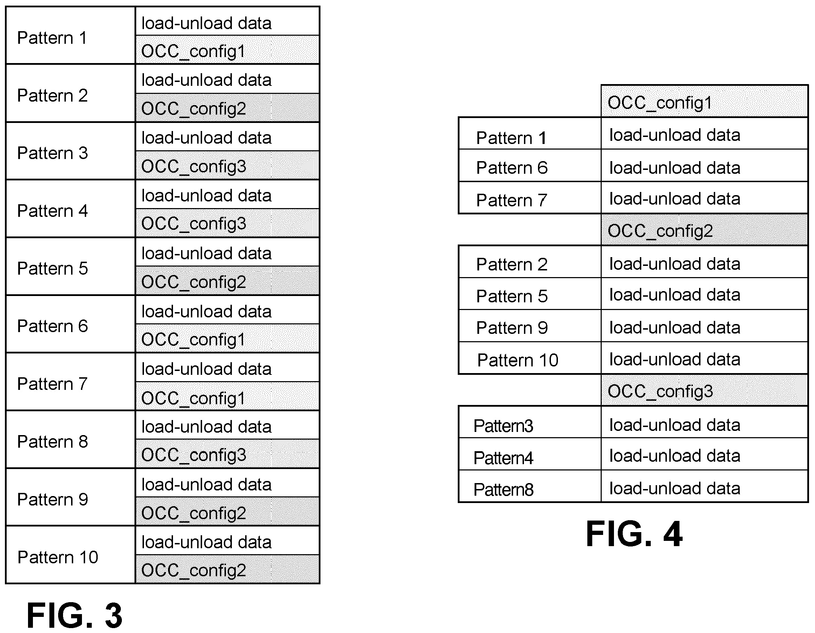

Consider now Figure 3, showing an embodiment having ten test clock TSTCLK patterns, labeled Patterns 1 through 10, to be sequentially produced. These patterns correspond to ten test steps to be performed. Observe that for each test clock TSTCLK pattern, an appropriate configuration of the clock bits CKBITS must be loaded by applying the corresponding clock chain input bits OCC[1], ..., OCC[m].

Each different configuration (e.g., value) of the clock chain input bits OCC[1], ..., OCC[m] is referred to as a different value of OCC_config. It can be observed that while ten test clock TSTCLK patterns are to be produced, in the embodiment considered, there are only three different configurations of the clock chain input bits to be loaded, denoted here as OCC_config1, OCC_config2, and OCC_config3. Specifically: Pattern 1, Pattern 6, and Pattern 7 are produced by providing clock chain input bits OCC[1], ..., OCC[m] corresponding to the configuration OCC_config1 to the clock chain 13; Pattern 2, Pattern 5, Pattern 9, and Pattern 10 are produced by providing clock chain input bits OCC[1], ..., OCC[m] corresponding to the configuration OCC_config2 to the clock chain 13; and Pattern 3, Pattern 4, and Pattern 8 are produced by providing clock chain input bits OCC[1], ..., OCC[m] corresponding to the configuration OCC_config3 to the clock chain 13.

In various embodiments, to optimize the testing process, the order of the tests can be rearranged so that tests utilizing the test clock TSTCLK patterns generated by the same value of OCC_config are grouped. As a result, loading of a different set of clock bits CKBITS from the appropriate clock chain input bits OCC[1], ..., OCC[m] need only be performed prior to executing the tests of each group.

For example, as shown in Figure 4, the test clock TSTCLK patterns 1, 6, and 7 generated by OCC_config1 can be grouped into a first group, the test clock TSTCLK patterns 2, 5, 9, and 10 generated by OCC_config2 can be grouped into a second group, and the test clock TSTCLK patterns 3, 4, and 8 generated by OCC_config3 can be grouped into a third group. Consequently, instead of requiring ten separate loadings of clock bits CKBITS to perform the ten tests that utilize the ten test clock TSTCLK patterns, the ten tests can be performed with only three loadings of the clock bits CKBITS. This optimization reduces the testing time and complexity while maintaining the necessary test requirements.

The operation of the load enable signal LOAD_EN becomes more efficient in the grouped testing approach, thanks to the reordering and grouping of tests based on their corresponding OCC_config values. Keep in mind that the enable buffer 31 is responsible for passing the test clock TSTCLK to the clock inputs of the clock chain 13 when LOAD_EN is asserted, while the enable buffer 32 passes the test clock TSTCLK to the clock inputs of the scan chains 22 when LOAD_EN is deasserted.

To begin performing a series of tests, LOAD_EN is asserted, which allows the enable buffer 31 to pass the test clock TSTCLK to the clock inputs of the clock chain 13, loading the appropriate clock bits CKBITS corresponding to the first OCC_config value from the corresponding clock chain input bits OCC[1], ..., OCC[m]. Next, LOAD_EN is deasserted, enabling the enable buffer 32 to pass the test clock TSTCLK to the clock inputs of the scan chains 22. The first group of tests with the same OCC_config value is executed during this phase, while the OCC data remains the same (frozen), eliminating the need to reload clock bits between tests within the same group.

When it is time to load the next OCC_config value, LOAD_EN is asserted again, allowing the enable buffer 31 to pass the test clock TSTCLK to the clock inputs of the clock chain 13 for loading the new OCC_config value from the corresponding clock chain input bits OCC[1], ..., OCC[m]. Meanwhile, the scan chains 22 retain their data (frozen). Once the new OCC_config value is loaded, LOAD_EN is deasserted, and the enable buffer 32 passes the test clock TSTCLK to the clock inputs of the scan chains 22, enabling the execution of the second group of tests corresponding to the newly loaded OCC_config value.

This process is repeated for all sets of OCC patterns, significantly reducing the frequency of toggling the LOAD_EN signal and minimizing the need to change the clock chain input bits OCC[1], ..., OCC[m] during testing. As a result, this leads to a more efficient testing process with reduced testing time.

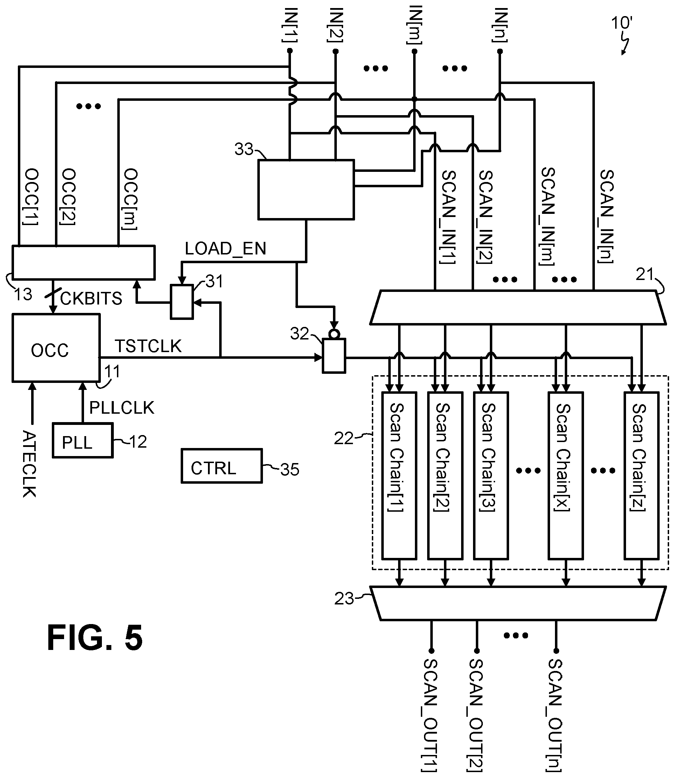

Referring now to Figure 5, a further embodiment is described in which the pin for the load enable signal LOAD_EN is eliminated. In this embodiment, the dedicated LOAD_EN pin is removed, and a pattern counter 33 is introduced.

The pattern counter 33 is a digital circuit that is coupled to the n input pins IN[1], ..., IN[n]. It keeps track of the number of test patterns executed during the testing process and generates the load enable signal LOAD_EN based on its count.

In more detail, the pattern counter 33 determines when to change the OCC_config value for the next group of tests. It receives signals from the n input pins IN[1], ..., IN[n] during the capture phase. The pattern counter 33 increments its count each time a test pattern is executed, monitoring the current position in the test sequence.

When the pattern counter 33 reaches a predetermined value, it triggers a change in the OCC_config value, initiating the process of loading new OCC data for the next group of tests. This approach eliminates the need for a dedicated LOAD_EN pin. During the testing process, the LOAD_EN signal generated by the pattern counter 33 is asserted or deasserted based on the current position in the test sequence. When the pattern counter value indicates that a new OCC _config value needs to be loaded, the LOAD_EN signal is asserted, allowing the enable buffer 31 to pass the test clock TSTCLK to the clock inputs of the clock chain 13.

Conversely, when the appropriate OCC_config value is loaded and the tests corresponding to that value are to be executed, the LOAD_EN signal is deasserted, enabling the enable buffer 32 to pass the test clock TSTCLK to the clock inputs of the scan chains 22. This may be performed through the pattern counter 33 including end-counter circuitry which counts the number of bits of OCC data that have been loaded. Once this count reaches a predesignated stop value (equal to the known total number of bits of OCC data), the LOAD_EN signal is deasserted.

In summary, test circuitry described herein offers several advantages over conventional test circuitry in integrated circuits. By sharing m input pins among both the scan compressor and clock chain, the test circuitry reduces the number of dedicated input pins needed, thereby saving valuable resources. Furthermore, by reordering and grouping test patterns based on their corresponding OCC_config values, the frequent changing of clock bits during the testing process is minimized, resulting in a more efficient testing process with reduced testing time.

Additionally, in an alternative embodiment where the load enable pin is eliminated, a pattern counter is introduced to generate the LOAD_EN signal based on its count. This approach not only eliminates the need for a dedicated LOAD_EN pin but also makes the testing process more efficient by tracking the current position in the test sequence and automatically triggering the change of OCC_config values when appropriate.

Accordingly, the present disclosure relates to test circuitry 10'. An OCC 11 generates a test-clock TSTCLK based on clock-bits CKBITS received from a clock-chain 13, with the test-clock operating scan-chains 22 and the clock-chain 13. The clock-chain 13 receives m clock-chain input bits from m of n input-pins, m being less than n, and provides the clock-bits CKBITS to the OCC 11 for generating the test-clock TSTCLK. The test circuitry 10' is configured to perform tests on the IC. Each test is associated with the test-clock TSTCLK generated by the OCC 11 based on a given set of clock-bits CKBITS. Specifically, in various embodiments, tests associated with the test-clock TSTCLK generated by the OCC 11 based on the same given set of clock-bits are performed after a single loading of that same given set of clock-bits (CKBITS). In various embodiments, the test circuitry comprises also a scan de-compressor 21 configured to receive n scan input bits SCAN_IN[n] from the n input pins and to de-compress the n scan input bits for distribution among z scan chains 22 as test data, where z is greater than n, and a scan compressor 23 configured to receive test response data from the z scan chains and to compress the test response data to thereby reconstruct n scan output bits SCAN_OUT[n].

Overall, the disclosed test circuitry optimization techniques enable efficient testing of integrated circuits, meeting the functional and performance requirements of the chip while reducing testing time, complexity, and the use of resources.

Example embodiments of the present invention are summarized here. Other embodiments can also be understood from the entirety of the specification and the claims filed herein.

Example 1. A test circuitry for an integrated circuit, comprising a scan de-compressor configured to receive n scan input bits from n input pins and to de-compress the n scan input bits for distribution among z scan chains as test data, where z is greater than n; a scan compressor configured to receive test response data from the z scan chains and to compress the test response data to thereby reconstruct n scan output bits; an on-chip clock controller (OCC) configured to generate a test clock signal based on clock bits received from a clock chain, the test clock signal configured to operate the z scan chains and the clock chain, wherein the clock chain is configured to receive m clock chain input bits from m of the n input pins, where m is less than n, and to provide the clock bits to the OCC for generating the test clock signal; control circuitry configured to control the test circuitry to perform a plurality of tests on the integrated circuit, with each test being associated with the test clock signal having been generated by the OCC based on a given set of clock bits; and wherein ones of the plurality of tests associated with the test clock signal having been generated by the OCC based on the same given set of clock bits are performed after a single loading of that same given set of clock bits.

Example 2. The test circuitry of Example 1, further comprising clock-control logic configured to pass the test clock signal to the clock chain in response to assertion of a load enable signal, and to pass the test clock signal to the z scan chains in response to deassertion of the load enable signal.

Example 3. The test circuitry of Example 1, further comprising a first enable buffer configured to pass the test clock signal to the clock chain in response to assertion of a load enable signal; and a second enable buffer configured to pass the test clock signal to the z scan chains in response to deassertion of the load enable signal.

Example 4. The test circuitry of Example 3, wherein the load enable signal is received via a load enable pin.

Example 5. The test circuitry of Example 3, further comprising a pattern counter coupled to the n input pins and configured to count a number of the tests executed on the integrated circuit and assert the load enable signal based upon the count.

Example 6. The test circuitry of Example 5, wherein the pattern counter is further configured to count a total number of clock chain input bits received by the clock chain during the performance of the plurality of tests and to deassert the load enable signal when the total number of clock chain input bits becomes equal to a predetermined value.

Example 7. A method for optimizing test circuitry in an integrated circuit, comprising grouping tests to be performed by the test circuitry on the integrated circuit into a plurality of groups, the grouping being according to which clock pattern is to be applied as a test clock to scan chains in the integrated circuit for each test such that each test using a same clock pattern is in a same group; and executing each group of tests by loading a clock controller with a set of clock bits that configure the clock controller to generate the test clock as having the clock pattern utilized by that group of tests, and performing each test of that group of tests, using the test clock, without reconfiguring the clock controller with a different set of clock bits between different tests of that group of tests.

Example 8. The method of Example 7, wherein there are z of the scan chains; further comprising receiving n scan input bits to be loaded into the scan chains at n input pins, and compressing the n scan input bits to produce input data for the z scan chains, with z being greater than n; and wherein each set of clock bits is received at m of the n input pins, with m being less than n.

Example 9. The method of Example 8, further comprising deasserting a load enable signal to cause passage of the test clock to a clock chain that provides the sets of clock bits to the clock controller prior to loading of the clock controller with the set of clock bits associated with a group of the tests to be performed, and asserting the load enable signal to the scan chains after the loading of the clock controller with the set of clock bits associated with a group of the tests to be performed.

Example 10. The method of Example 9, further comprising counting a number of sets of clock bits that have been loaded in the clock controller; and wherein the load enable signal is asserted and deasserted based upon the count.

Example 11. The method of Example 9, wherein the load enable signal is received via a load enable pin.

Example 12. The method of Example 9, further comprising counting a number of the tests performed on the integrated circuit and assert the load enable signal based upon that count.

Example 13. The method of Example 12, further comprising counting a total number of the clock bits received during the performance of the tests and deasserting the load enable signal when the total number of those clock bits becomes equal to a predetermined value.

Example 14. A test circuitry for an integrated circuit, comprising an on-chip clock controller (OCC) configured to generate a test clock signal based on clock bits received from a clock chain, the test clock signal configured to operate the clock chain; wherein the clock chain is configured to receive m clock chain input bits from m of n input pins, where m is less than n, and to provide the clock bits to the OCC for generating the test clock signal; control circuitry configured to control the test circuitry to perform a plurality of tests on the integrated circuit, with each test being associated with the test clock signal having been generated by the OCC based on a given set of clock bits; and wherein ones of the plurality of tests associated with the test clock signal having been generated by the OCC based on the same given set of clock bits are performed after a single loading of that same given set of clock bits.

Example 15. The test circuitry of Example 14, further comprising clock-control logic configured to pass the test clock signal to the clock chain in response to assertion of a load enable signal.

Example 16. The test circuitry of Example 14, further comprising a first enable buffer configured to pass the test clock signal to the clock chain in response to assertion of a load enable signal.

Example 17. The test circuitry of Example 16, wherein the load enable signal is received via a load enable pin.

Example 18. The test circuitry of Example 16, further comprising a pattern counter coupled to the n input pins and configured to count a number of the tests executed on the integrated circuit and assert the load enable signal based upon the count.

Example 19. The test circuitry of Example 18, wherein the pattern counter is further configured to count a total number of clock chain input bits received by the clock chain during the performance of the plurality of tests and to deassert the load enable signal when the total number of clock chain input bits becomes equal to a predetermined value.

It is evident that modifications and variations can be made to what has been described and illustrated herein without departing from the scope of this disclosure.

Although this disclosure has been described with a limited number of embodiments, those skilled in the art, having the benefit of this disclosure, can envision other embodiments that do not deviate from the disclosed scope. Furthermore, skilled persons can envision embodiments that represent various combinations of the embodiments disclosed herein made in various ways.

## Claims

1. A test circuitry (10') for an integrated circuit, comprising:
- an on-chip clock controller, OCC, (11) configured to generate a test clock signal (TSTCLK) based on clock bits (CKBITS) received from a clock chain (13), the test clock signal (TSTCLK) configured to operate z scan chains (22) and the clock chain (13);
wherein the clock chain (13) is configured to receive m clock chain input bits (OCC[m]) from m of n input pins, where m is less than n, and to provide the clock bits (CKBITS) to the OCC (11) for generating the test clock signal (TSTCLK);
- control circuitry (35) configured to control the test circuitry to perform a plurality of tests on the integrated circuit, with each test being associated with the test clock signal (TSTCLK) having been generated by the OCC (11) based on a given set of clock bits (CKBITS); and
wherein ones of the plurality of tests associated with the test clock signal having been generated by the OCC based on the same given set of clock bits are performed after a single loading of that same given set of clock bits.

2. The test circuitry (10') of claim 1, further comprising
- a scan de-compressor (21) configured to receive n scan input bits (SCAN _IN[n]) from the n input pins and to de-compress the n scan input bits for distribution among z scan chains (22) as test data, where z is greater than n; and
- a scan compressor (23) configured to receive test response data from the z scan chains and to compress the test response data to thereby reconstruct n scan output bits (SCAN_OUT[n]).

3. The test circuitry (10') of claim 1 or claim 2, further comprising clock-control logic (31, 32) configured to pass the test clock signal (TSTCLK) to the clock chain (13) in response to assertion of a load enable signal (LOAD_EN), and to pass the test clock signal (TSTCLK) to the z scan chains (22) in response to deassertion of the load enable signal.

4. The test circuitry (10') of any of the previous claims, further comprising:
- a first enable buffer (31) configured to pass the test clock signal (TSTCLK) to the clock chain (13) in response to assertion of a load enable signal (LOAD_EN); and
- a second enable buffer (32) configured to pass the test clock signal (TSTCLK) to the z scan chains (22) in response to deassertion of the load enable signal.

5. The test circuitry (10') of claim 4, wherein the load enable signal (LOAD_EN) is received via a load enable pin.

6. The test circuitry (10') of claim 4, further comprising a pattern counter (33) coupled to the n input pins and configured to count a number of the tests executed on the integrated circuit and assert the load enable signal (LOAD_EN) based upon the count.

7. The test circuitry (10') of claim 6, wherein the pattern counter (33) is further configured to count a total number of clock chain input bits (OCC[m]) received by the clock chain during the performance of the plurality of tests and to deassert the load enable signal when the total number of clock chain input bits (OCC[m]) becomes equal to a predetermined value.

8. A method for optimizing test circuitry (10'), comprising:
- grouping tests to be performed by the test circuitry on the integrated circuit into a plurality of groups, the grouping being according to which clock pattern is to be applied as a test clock (TSTCLK) to scan chains (22) in the integrated circuit for each test such that each test using a same clock pattern is in a same group;
- executing each group of tests by:
- loading a clock controller (11) of the test circuitry with a set of clock bits (CKBITS) that configure the clock controller to generate the test clock (TSTCLK) as having the clock pattern utilized by that group of tests; and
- performing each test of that group of tests, using the test clock, without reconfiguring the clock controller (11) with a different set of clock bits between different tests of that group of tests.

9. The method of claim 8, wherein there are z of the scan chains (22), the method further comprising:
- receiving n scan input bits (SCAN_IN) to be loaded into the scan chains (22) at n input pins; and
- compressing the n scan input bits to produce input data for the z scan chains (22), with z being greater than n; and
wherein each set of clock bits (OCC[m]) is received at m of the n input pins, with m being less than n.

10. The method of claim 9, further comprising:
- deasserting a load enable signal (LOAD_EN) to cause passage of the test clock (TSTCLK) to a clock chain (13) that provides the sets of clock bits (CKBITS) to the clock controller (11) prior to loading of the clock controller with the set of clock bits associated with a group of the tests to be performed; and
- asserting the load enable signal to the scan chains (22) after the loading of the clock controller with the set of clock bits associated with a group of the tests to be performed.

11. The method of claim 10, further comprising counting a number of sets of clock bits (CKBITS) that have been loaded in the clock controller (11); and wherein the load enable signal (LOAD_EN) is asserted and deasserted based upon the count.

12. The method of claim 10, wherein the load enable signal (LOAD_EN) is received via a load enable pin.

13. The method of claim 10, further comprising counting a number of the tests performed on the integrated circuit and assert the load enable signal (LOAD_EN) based upon that count.

14. The method of claim 13, further comprising counting a total number of the clock bits (CKBITS) received during the performance of the tests and deasserting the load enable signal (LOAD_EN) when the total number of those clock bits becomes equal to a predetermined value.
